# EUROPEAN PATENT SPECIFICATION

(11) **EP 2 032 235 B1**
(45) Date of publication and mention of the grant of the patent: **01.09.2010**
(21) Application number: 07733698.0
(22) Date of filing: 21.05.2007
(51) Int. Cl.: B01D 53/32

(54) **METHOD AND APPARATUS FOR TREATING A GAS STREAM**
VERFAHREN UND VORRICHTUNG ZUR BEHANDLUNG EINES GASSTROMS
PROCÉDÉ ET APPAREIL POUR LE TRAITEMENT D'UN FLUX DE GAZ

(30) Priority: 28.06.2006 GB 0612814
(43) Date of publication of application: 11.03.2009
(73) Proprietor: Edwards Limited, Crawley, West Sussex RH10 9LW (GB)
(72) Inventor: SEELEY, Andrew James, Somerset BS21 6TH (GB); ABREU ABREU, Raul Antonio, West Sussex RH12 5TH (GB)
(74) Representative: Clark, Charles Robert
(86) International application number: PCT/GB2007/050277
(87) International publication number: WO 2008/001129

(56) References cited:
- EP-A1- 0 821 995
- US-A- 6 045 618
- US-A1- 2001 020 582

## Description

The present invention relates to a method of, and apparatus for, treating a gas stream. The invention may be used in the treatment of a gas stream exhausted from a process chamber to which gas is supplied by a pulsed gas delivery system, or in the treatment of a gas stream exhausted from any other process chamber.

Pulsed gas delivery systems are commonly used in the formation of multilayer thin films on a batch of substrates located in a process chamber. One such technique for forming thin films on substrates is atomic layer deposition (ALD), in which gaseous reactants, or "precursors", are sequentially delivered to a process chamber to form very thin layers, usually on an atomic-layer scale, of materials on the substrates.

By way of example, a high dielectric constant capacitor may be formed on a silicon wafer using an ALD technique. Dielectric layers that may be deposited using an ALD technique may include hafnium oxide (HfO₂), aluminium oxide (Al₂O₃), titanium dioxide (TiO₂), zirconium oxide (ZrO₂) or any mixture thereof. Precursors for the formation of such dielectric thin films have the general formula AlR₃, where R is an organic radical, M(NR₂)₄, where M is one of Ti, Zr and Hf, and M(NR'R)₄; where R and R' are different organic radicals.

In overview, the first precursor delivered to the process chamber is adsorbed on to the surfaces of the substrates within the process chamber. The non-adsorbed first precursor is drawn from the process chamber by a vacuum pumping system, and the second precursor is then delivered to the process chamber for reaction with the first precursor to form a layer of deposited material. In the deposition chamber, the conditions immediate to the substrates are optimised to minimise gas-phase reactions and maximise surface reactions for the formation of a continuous film on each substrate. Any non-reacted second precursor and any by-products from the reaction between the precursors is then removed from the process chamber by the pumping system. Depending on the structure being formed within the process chamber, the first precursor, or a third precursor, is then delivered to the process chamber.

A purge step is typically carried out between the delivery of each precursor, for example by delivering a purge gas, such as N₂ or Ar, to the chamber between the delivery of each precursor. The purpose of the purge gas delivery is to remove any residual precursor from the process chamber so as to prevent unwanted reaction with the next precursor supplied to the chamber.

In practice, only around 5% or less of the precursors supplied to the process chamber are consumed during the deposition process, and so the gas drawn from the chamber during the process chamber will, between supplies of purge gas to the chamber, alternately be rich in the first precursor, and then rich in the second precursor.

In convention vacuum pumping systems, the gases drawn from the process chamber enter a common foreline leading to a vacuum pump. In the event that the non-reacted precursors meet within the vacuum pumping system, cross-reaction of the precursors can occur, and this can result in both the deposition of solid material and the accumulation of powders within the foreline and the vacuum pump. Particulates and powders that have accumulated within the pump can effectively fill the vacant running clearance between the rotor and stator elements of the pump, leading to a loss of pumping performance and ultimately pump failure. Periodic pump cleaning or replacement is then required to maintain pumping performance, resulting in costly process downtime and increasing manufacturing costs.

EP821995 describes a process for the scrubbing of undesirable substances from an exhaust gas stream which comprises passing the stream through a hollow cathode.

US6045618 describes an apparatus for minimizing deposition in an exhaust line of a substrate processing chamber, which includes first and second members having opposing surfaces defining a fluid conduit between them.

In US2001/020582 a method and an apparatus for plasma treatment of gas, particularly for transformation, passivation and stabilization of polluting and toxic admixtures is disclosed.

It is an aim of at least the preferred embodiment of the present invention to seek to solve this problem.

In a first aspect, the present invention provides a method of treating a gas stream exhausted from a process chamber to which a first gaseous precursor and a second gaseous precursor are alternately supplied, the method comprising the steps, upstream from a vacuum pump used to draw the gas stream from the chamber, of conveying the gas stream through a gas passage surrounded by a plurality of hollow cathodes, conveying through the hollow cathodes a source of reactive species for reacting with one of the first and second gaseous precursors, applying a potential to the hollow cathodes to form the reactive species from said source, and, downstream from the gas passage, mixing the reactive species with the gas stream.

Through the application of a (negative) potential to the hollow cathodes, the source of reactive species can be dissociated into reactive species, such ions, radicals and electrons, in a plasma. By deliberately reacting, say, unconsumed first gaseous precursor with the reactive species emitted from the hollow cathodes before it reaches the pump, reaction within the pump of the unconsumed first gaseous precursor with unconsumed second gaseous precursor subsequently drawn from the chamber by the pump can be inhibited. Conveying the source of reactive species through the hollow cathodes in isolation from the gas to be treated can inhibit the deposition of by-products from the reaction between the reactive species and the gas to be treated within the hollow cathodes.

The source of the reactive species is preferably a gas that is relatively cheap, safe and readily available. In order to minimise the number of gas supplies the source of reactive species may be the second gaseous precursor, which is supplied from a second precursor supply both to the process chamber and to the hollow cathodes to form reactive species for reaction with the first gaseous precursor. In this case, the source of reactive species may be either an oxidising agent or a reducing agent used in the process conducted within the process chamber. In the preferred embodiments, the source of reactive species is an oxidising agent, and so the second gaseous species may be ozone, and the first gaseous precursor may be an organometallic precursor, which may comprise one of hafnium and aluminium. Examples include tetrakis(ethylmethylamino)hafnium (TEMAH) and trimethyl aluminium (TMA).

As an alternative to using the second gaseous precursor as the oxidant, an oxidant such as O₂ may be supplied to the hollow cathodes from a separate source to form oxygen radicals and ions for reaction with the first gaseous precursor.

As this method is suitable for use in treating a gas stream other than that exhausted from a process chamber to which a first gaseous precursor and a second gaseous precursor are alternately supplied, in a second aspect the present invention provides a method of treating a gas stream, the method comprising the steps of conveying the gas stream through a gas passage surrounded by a plurality of hollow cathodes, conveying through the hollow cathodes a gaseous source of reactive species for reacting with a component of the gas stream, applying a potential to the hollow cathodes to form the reactive species from said source, and, downstream from the gas passage, mixing the reactive species with the gas stream.

In either of the above aspects, each hollow cathode preferably comprises a hollow cylindrical tube. The cylindrical tubes are preferably substantially parallel to the gas passage. The cylindrical tubes preferably comprise a plurality of bores formed in an electrically conductive body at least partially housing the gas passage. The outlets from the hollow cathodes are preferably substantially co-planar with the outlet from the gas passage. A plurality of the gas passages may be provided, and arranged such that the gas stream passes through the gas passages in parallel, each gas passage being surrounded by a plurality of hollow cathodes.

The gas passage preferably passes through a plenum chamber having an inlet for receiving the source of reactive species, and a plurality of outlets from which the source of reactive species is supplied to the hollow cathodes. The plenum chamber is preferably formed from electrically insulating material. An anode is preferably located downstream from the gas passage and the hollow cathodes, the anode having apertures aligned with the gas passage and the hollow cathodes to permit the gas stream and the reactive species to pass through the anode. The reactive species may subsequently mix with the gas stream within a reactor chamber located downstream from the gas passage. The reactor chamber may be either heated or thermally insulated to promote reaction between the reactive species and the component of the gas stream.

In the event that the reaction results in the formation of solid material, a separator may be provided between the gas passage and the vacuum pump for separating from the gas stream solid material, such as dust and/or particulates, produced from the reaction. The separator may be provided by any trap device for removing solid material from a gas stream. One example is a dead-leg type of trap device. In the preferred embodiment, the separator is provided by a cyclone separator. An advantage associated with the use of a cyclone separator to separate the solid material from the gas stream is that the solid material will settle out in the bottom of the cyclone separator without increasing the impedance of the separator to the flow of the gas stream. Two or more cyclone separators may be provided in parallel to increase gas conductance.

In a third aspect the present invention provides apparatus for treating a gas stream, the apparatus comprising a gas passage for receiving the gas stream, a plurality of hollow cathodes located about the gas passage, means for supplying to the hollow cathodes a gaseous source of reactive species for reacting with a component of the gas stream, means for applying a potential to the hollow cathodes to form the reactive species from said source, and a reaction chamber for receiving the gas stream and the reactive species.

In a fourth aspect the present invention provides apparatus for treating a gas stream exhausted from a process chamber to which a first gaseous precursor and a second gaseous precursor are alternately supplied, the apparatus comprising a gas passage for receiving the gas stream, a plurality of hollow cathodes located about the gas passage, means for supplying to the hollow cathodes a gaseous source of reactive species for reacting with one of the first and second gaseous precursors, means for applying a potential to the hollow cathodes to form the reactive species from said source, and a reaction chamber for receiving the gas stream and the reactive species.

In a fifth aspect the present invention provides an atomic layer deposition apparatus comprising a process chamber, a first gaseous precursor supply for supplying a first gaseous precursor to the chamber, a second gaseous precursor supply for supplying a second gaseous precursor to the chamber, a vacuum pump for drawing a gas stream from the process chamber, and, between the process chamber and the vacuum pump, a plurality of gas passages for receiving the gas stream from the process chamber, and a plurality of hollow cathodes located about the gas passages for receiving second gaseous precursor from the second precursor gas supply, the apparatus comprising means for applying a potential to the hollow cathodes to form from the second gaseous precursor reactive species for reacting with first gaseous precursor within the gas stream to form solid material, a reaction chamber for receiving the gas stream and the reactive species, and a separator for receiving a gas stream exhausted from the reaction chamber and separating solid material from that gas stream.

Features described above in relation to method aspects of the invention are equally applicable to apparatus aspects, and vice versa.

Preferred features of the present invention will now be described, by way of example only, with reference to the accompanying drawings, in which:
Figure 1 illustrates schematically an atomic layer deposition apparatus including apparatus for treating the gas stream exhaust from the process chamber;
Figure 2 illustrates the sequence of supply of gases to the process chamber of the apparatus of Figure 1;
Figure 3 illustrates in more detail the apparatus for treating the gas stream;
Figure 4 is a cross-sectional view of the apparatus of Figure 3; and
Figure 5 illustrates apparatus for treating a gas stream separate from any process apparatus.

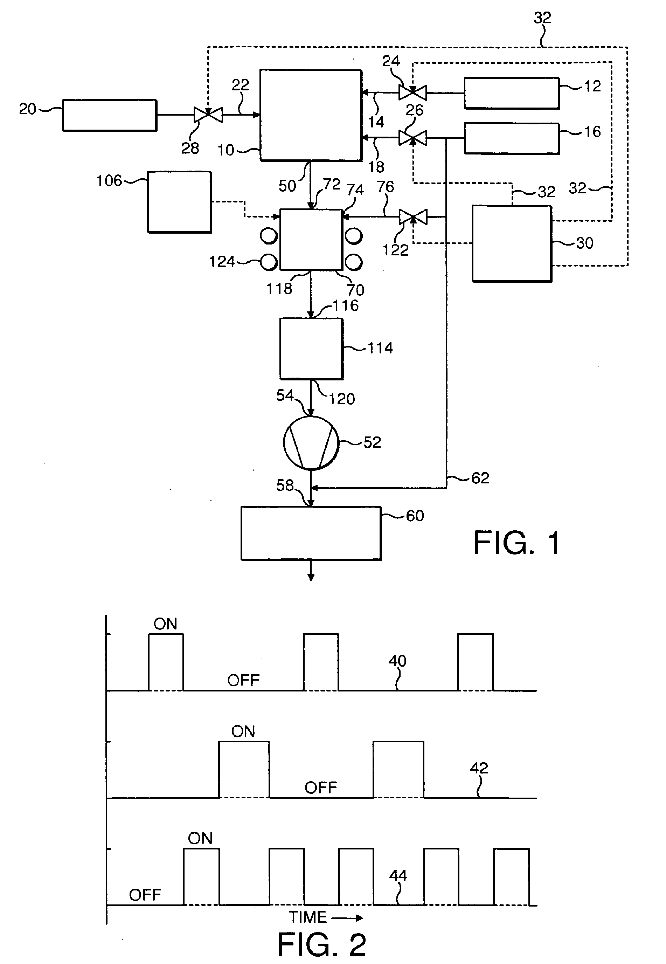

With reference first to Figure 1, an atomic layer deposition (ALD) apparatus comprises a process chamber 10 for receiving a batch of substrates to be processed simultaneously within the process chamber 10. The process chamber 10 receives separately and alternately two or more different gaseous reactants or precursors for use in forming layers of material on the exposed surfaces of the substrates. In the example illustrated in Figure 1, a first precursor supply 12 is connected to the process chamber 10 by a first precursor supply line 14 for supplying a first precursor to the process chamber 10, and a second precursor supply 16 is connected to the process chamber 10 by a second precursor supply line 18 for supplying a second precursor to the process chamber 10. A purge gas supply 20 is also connected to the process chamber 10 by a purge gas supply line 22 for supplying a purge gas such as nitrogen or argon to the process chamber 10 between the supply of the precursors to the process chamber 10.

The supply of the precursors and the purge gas to the process chamber 10 is controlled by the opening and closing of gas supply valves 24, 26, 28 located in the supply lines 14, 18, 22 respectively. The operation of the gas supply valves is controlled by a supply valve controller 30 which issues control signals 32 to the gas supply valves to open and close the valves according to a predetermined gas delivery sequence. A typical gas delivery sequence involving two gaseous precursors and a purge gas is illustrated in Figure 2. The first trace 40 represents the stepped delivery sequence for the first gaseous precursor, and the second trace 42 represents the stepped delivery sequence for the second gaseous precursor. As described above, the first and second precursors are alternately supplied to the chamber to form layers of solid material on the batches of substrates located within the process chamber 10. The duration of each pulsed delivery of precursor to the process chamber 10 is defined for the particular process to be performed within the process chamber 10; in this example, the duration of each pulsed delivery of the second precursor to the process chamber 10 is longer than that for the first precursor. The third trace 44 represents the stepped delivery sequence for the purge gas that is introduced into the process chamber 10 between the delivery of first and second gaseous precursors to flush the process chamber 10 before introducing the next gaseous precursor.

Returning to Figure 1, a vacuum pumping system is connected to the outlet 50 of the process chamber 10 for drawing a gas stream from the process chamber 10. The pumping system comprises a vacuum pump 52 for receiving the gas stream through an inlet 54 thereof and exhausting the gas stream at an elevated pressure through an exhaust 56 thereof. The gas stream exhausted from the vacuum pump 52 is conveyed to an inlet 58 of an abatement device 60, for example a thermal processing unit or a wet scrubber, for removing one or more species from the gas stream before it is exhausted to the atmosphere.

In one example, the first gaseous precursor is an organometallic precursor containing one of hafnium and aluminium, such as tetrakis(ethylmethylamino) hafnium (TEMAH) or trimethyl aluminium (TMA), and the second gaseous precursor is an oxidant, such as ozone. The second precursor supply 16 may therefore be provided by an ozone generator. Currently available ozone generators can be difficult to start and stop in synchronisation with the pulsed delivery sequence of ozone to the process chamber 10. In view of this, the ozone generator 16 may be continuously generating ozone during the ALD process, and when ozone is not being delivered to the process chamber 10 the ozone may be diverted along ozone supply line 62 to a location downstream from the vacuum pump 52, for example to the inlet of a backing pump (not illustrated) provided between the vacuum pump 52 and the abatement device 60, or directly to a second inlet of the abatement device 60, where the ozone may assist in the abatement of the gas stream exhausted from the vacuum pump 52.

In view of the alternating supply of first and second gaseous precursors to the process chamber 10, the gas stream drawn from the process chamber 10 will alternate between a first precursor-rich gas stream, comprising unconsumed first precursor and by-products from the reaction between the precursors, and a second precursor-rich gas stream, comprising unconsumed second precursor and the by-products, with a purge gas-rich gas stream being drawn from the process chamber 10 between these precursor-rich gases. Each of the precursor-rich gas streams is also likely to contain traces of purge gas and other contaminants.

In order to inhibit mixing of the unconsumed precursors within the vacuum pump 52, which could lead to undesirable reaction between the precursors and the formation of dust and/or powders within the vacuum pump, apparatus 70 is provided between the outlet 50 of the process chamber 10 and the inlet 54 of the vacuum pump 52 to treat the gas stream exhausted from the process chamber 10 so as to reduce the amount of one of the first and second precursors that enters the vacuum pump 52. In the example illustrated in Figure 1, the amount of the first precursor entering the vacuum pump 52 is reduced.

The apparatus 70 for treating the gas stream exhausted from the process chamber 10 has a first inlet 72 for receiving the gas stream exhausted from the process chamber 10, and a second inlet 74 for receiving a source of reactive species for reacting with the chosen precursor to be at least partially removed from the gas stream. In the illustrated example, a supply for supplying the source of reactive species to the apparatus 70 is conveniently provided by the ozone generator 16. A reactant supply line 76 is connected between the ozone supply line 62 and the second inlet 74 of the gas mixing chamber 70 to supply ozone to the apparatus 70.

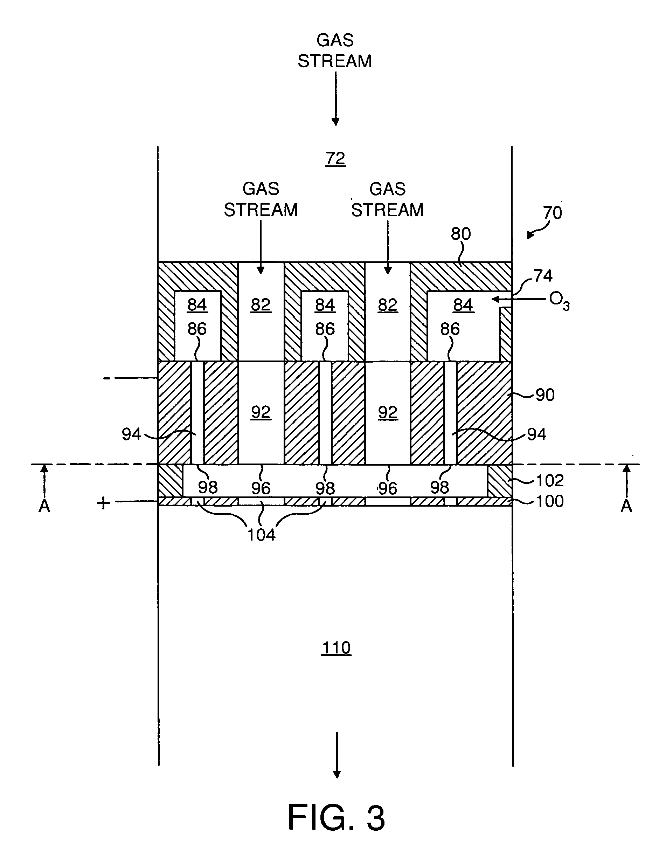

Part of the apparatus 70 is illustrated in more detail in Figure 3. The apparatus 70 comprises an electrically insulating body 80 having a plurality of parallel, cylindrical bores 82 extending therethrough for receiving the gas stream from the first inlet 72. The body 80 also defines a plenum chamber 84 located about the bores 82, and which receives the source of reactive species from the second inlet 74. The plenum chamber 84 has a plurality of cylindrical outlets 86 surrounding the bores 82 through which the source of reactive species is exhausted from the plenum chamber 84.

The apparatus 70 also comprises a cathode 90 located downstream from the electrically insulating body 80. The cathode 90 is provided by an electrically conducting body having a first set of parallel, cylindrical bores 92 extending therethrough for receiving the gas stream from the channels 82. The bores 92 in the cathode 90 have substantially the same diameter as the bores 82 in the body 80. The bores 82 of the body 80 and the bores 92 of the cathode 90 together define gas passages arranged such that the gas stream passes through the gas passages in parallel.

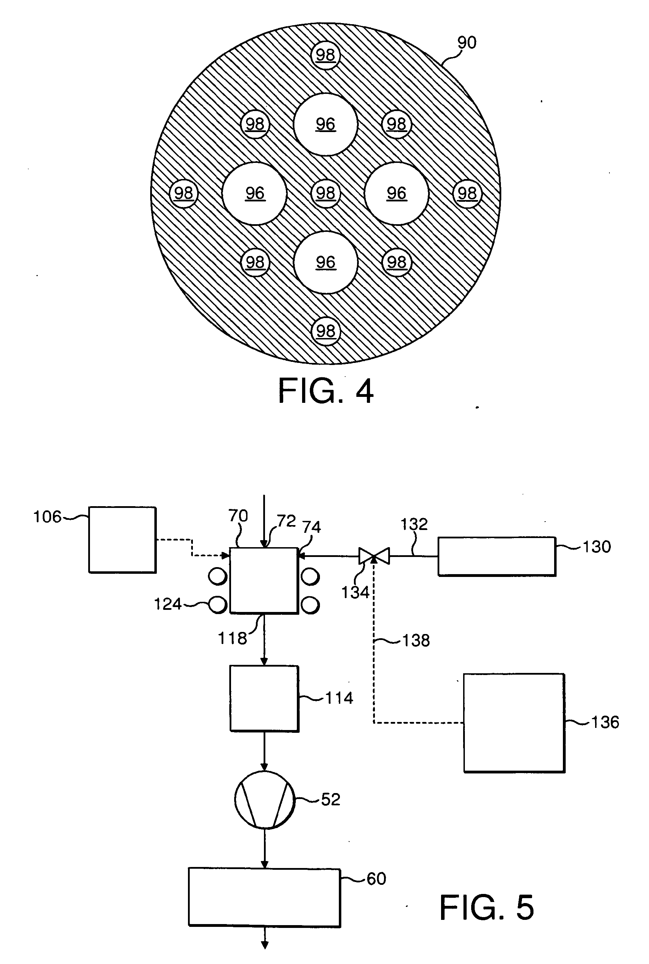

The cathode 90 also has a second set of bores 94 extending therethrough for receiving the gas stream from the outlets 86 of the body 80. The diameter of the bores 94 is smaller than the diameter of the bores 92. The bores 94 are axially aligned with the outlets 86 from the plenum chamber 84, and are arranged substantially parallel to the bores 92. The outlets 96 from the bores 92 are substantially co-planar with the outlets 98 from the bores 94. With reference to Figure 4, each of the bores 92 is surrounded by a plurality of the smaller bores 94, in this example by four bores but the bores 92 may be surrounded by any number of the smaller bores 94.

The apparatus further comprises an anode 100 spaced from the cathode by an electrical insulator 102. The anode 100 has a plurality of apertures 104 which are aligned with the outlets 96, 98 of the bores 92, 94 of the cathode 90. A power source 106 is provided to charge the cathode 90 to a cathode (negative) potential and the anode 100 to an anode (positive) potential.

The application of the negative potential to the cathode 90 causes the bores 94 to act as hollow cathodes, which results in the dissociation of the source of reactive species, in this example ozone, into reactive species, in this example electrons, oxygen ions and oxygen radicals, in a plasma. The reactive species and the gas stream pass through the apertures 104 in the anode 100 and enter a reaction chamber 110 within which the reactive species react with unconsumed first gaseous precursor in the gas stream.

The source of reactive species is preferably chosen so that the reaction that takes place within the reaction chamber 110 replicates the reaction that would occur between unconsumed first and second gaseous precursors within the vacuum pump 52. Therefore, a product from the reaction between the reactive species and the first gaseous precursor is the solid material, such as a dust and/or powder, that would otherwise be formed in the vacuum pump 52 through the reaction between the unconsumed precursors. Consequently, the a separator 114 may be provided for removing this solid material from the gas stream exhausted from the reaction chamber 110 before it enters the vacuum pump 52. With reference to Figure 1, the separator 114 has an inlet 116 connected to an outlet 118 of the apparatus 70. The separator 114 is preferably a cyclone separator, which receives the solid material-laden gas stream from the apparatus 70, and, in a manner known in the art, separates the solid material from the gas stream, retaining the solid material therewithin and exhausting the gas stream from an outlet 120 thereof to the inlet 54 of the vacuum pump 52.

The supply of the source of reactive species to the apparatus 70 is controlled by the opening and closing of reactant supply valve 122 located in the reactant supply line 76. The operation of the reactant supply valve 122 is controlled by the supply valve controller 30, which issues control signals 32 to the reactant supply valve 76 to open and close in synchronisation with the delivery of the first gaseous precursor to the process chamber 10, so that the source of reactive species is supplied to the apparatus 70 with a stepped delivery sequence that is similar to that for the first gaseous precursor. The amount of source of reactive species periodically delivered to the apparatus 70 is preferably at least sufficient to react with the amount of the first gaseous precursor that is supplied to the process chamber 10.

In order to increase the reaction rate between the reactive species and the first gaseous precursor within the reaction chamber 110, a heater 124 may optionally extend about the reaction chamber 110 for heating the reaction chamber 110. Alternatively, the reaction chamber 110 may be thermally insulated.

In the example illustrated in Figure 1, the apparatus 70 is separate from the separator 114. However, the apparatus 70 may be mounted on, or integral with, the separator 114. Two or more separators 114 may be provided in parallel to enable one separator to be serviced while the other is operational.

The apparatus 70 has been described above as part of an ALD apparatus 10. However, the apparatus 70 may be used to treat gas streams other than those exhausted from an ALD process chamber. For example, the apparatus 70 may be used to treat gases exhausted from a CVD or other deposition chamber, or any other gas stream containing a component, for example NH₃, which may be detrimental to the vacuum pump 52. Figure 5 illustrates an example in which the apparatus is used to treat any gas stream. In view of the absence of the source of the second precursor gas for supplying the source of reactive species to the second inlet 74 of the apparatus 70, a separate source 130 of reactive species, in this example an oxidant such as oxygen, is connected to the second inlet 74 by a reactant supply line 132. The supply of oxygen to the apparatus 70 is controlled by opening and closing valve 134. As illustrated in Figure 5, a controller 136 may be provided by issuing signals 138 to the valve 134 to control the supply of oxygen to the apparatus 70. Depending on the nature of the reaction between the reactive species and the component of the gas stream, a separator 114 may again be provided downstream from, or integral with, the apparatus 70. This separator 114 may be provided by a cyclone trap for removing particulates from the gas stream, a cold trap for removing condensable species from the gas stream, or a hot trap.

## Claims

1. A method of treating a gas stream, the method comprising the steps of conveying the gas stream through a gas passage (92) surrounded by a plurality of hollow cathodes (90), conveying through a plurality of hollow cathodes (90) a gaseous source of reactive species for reacting with a component of the gas stream exhausted from the gas passage, applying a potential to the hollow cathodes to form the reactive species from said source, and, downstream from the gas passage, mixing the reactive species with the gas stream.

2. A method according to Claim 1, further comprising passing the gas stream through a plurality of said gas passages arranged such that the gas stream passes through the gas passages in parallel, each gas passage being surrounded by a plurality of hollow cathodes.

3. A method according to Claim 1 or 2, further comprising mixing the reactive species with the gas stream within a reactor chamber located downstream from the gas passage.

4. A method according to Claim 3, further comprising heating the reactor chamber to promote reaction between the reactive species and the component of the gas stream.

5. A method according to any preceding claim, further comprising conveying the gas stream to a separator to separate solid material from the gas stream.

6. Gas stream treatment apparatus (70) comprising a gas passage (72, 82, 92) for receiving the gas stream, a plurality of hollow cathodes (90) located about the gas passage, means (84) for supplying to the hollow cathodes a gaseous source of reactive species for reacting with a component of the gas stream, means for applying a potential to the hollow cathodes to form the reactive species from said source, and a reaction chamber (110) for receiving the gas stream and the reactive species.

7. Apparatus according to Claim 6, wherein each hollow cathode comprises a hollow cylindrical tube, the cylindrical tubes are substantially parallel to the gas passage, and the cylindrical tubes comprise a plurality of bores (92, 94) formed in an electrically conductive body at least partially housing the gas passage.

8. Apparatus according to Claim 7, wherein the supply means comprises a plenum chamber (84) having an inlet (74) for receiving the source of reactive species, and a plurality of outlets (98) from which the source of reactive species is supplied to the hollow cathodes.

9. Apparatus according to Claim 6, comprising an anode (100) located downstream from the gas passage and the hollow cathode, the anode having apertures (104) aligned with the gas passage and the hollow cathodes.

10. Apparatus according to any of Claims 6 to 9, comprising a plurality of said gas passages arranged such that the gas stream passes through the gas passages in parallel, each gas passage being surrounded by a plurality of hollow cathodes.

11. Apparatus according to any of Claims 6 to 10, comprising either a heater (124) for heating the reaction chamber to promote reaction between the reactive species and the component of the gas stream, or wherein the reactor chamber is thermally insulated to promote reaction between the reactive species and the component of the gas stream.

12. Apparatus according to any of Claims 6 to 11, comprising a separator (114) for receiving a gas stream exhausted from the reaction chamber and separating solid material from that gas stream.

13. Apparatus according to Claim 6, wherein said apparatus is arranged for treating a gas stream exhausted from a process chamber to which a first gaseous precursor and a second gaseous precursor are alternately supplied, and wherein the means for supplying a gaseous source to the hollow cathode is arranged for supplying a gaseous source of reactive species for reacting with one of the first and second gaseous precursors.

14. Apparatus according to Claim 13, wherein said one of the first and second gaseous precursors is the first gaseous precursor, and the source of reactive species is the second gaseous precursor.

15. Apparatus according to any of Claims 13 or 14, wherein the first gaseous precursor is an organometallic precursor.

## Patentansprüche

1. Verfahren zur Behandlung eines Gasstroms, wobei das Verfahren die Schritte des Förderns des Gasstroms durch einen Gaskanal (92), der von einer Mehrzahl hohler Kathoden (90) umgeben ist, des Förderns einer gasförmigen Quelle reaktiver Spezien zum Reagieren mit einer Komponente des aus dem Gaskanal austretenden Gasstroms durch eine Mehrzahl hohler Kathoden (90), des Anlegens eines Potentials an die hohlen Kathoden zur Bildung der reaktiven Spezien aus der genannten Quelle, und des Mischens der reaktiven Spezien mit dem Gasstrom stromab des Gaskanals umfasst.

2. Verfahren nach Anspruch 1, das weiter das Leiten des Gasstroms durch eine Mehrzahl der genannten Gaskanäle umfasst, die so angeordnet sind, dass der Gasstrom parallel durch die Gaskanäle gelangt, wobei jeder Gaskanal durch eine Mehrzahl hohler Kathoden umgeben ist.

3. Verfahren nach Anspruch 1 oder 2, das weiter das Mischen der reaktiven Spezien mit dem Gasstrom innerhalb einer Reaktorkammer umfasst, die stromab des Gaskanals angeordnet ist.

4. Verfahren nach Anspruch 3, das weiter das Beheizen der Reaktorkammer zur Begünstigung der Reaktion zwischen den reaktiven Spezien und der Komponente des Gasstroms umfasst.

5. Verfahren nach irgendeinem vorhergehenden Anspruch, das weiter das Fördern des Gasstroms zu einem Abscheider zum Abscheiden von festem Material aus dem Gasstrom umfasst.

6. Gasstrom-Behandlungseinrichtung (70) mit einem Gaskanal (72, 82, 92) zur Aufnahme des Gasstroms, einer Mehrzahl hohler Kathoden (90), die um den Gaskanal herum angeordnet sind, Mitteln (84) zum Zuführen einer gasförmigen Quelle reaktiver Spezien zum Reagieren mit einer Komponente des Gasstroms zu den hohlen Kathoden, Mitteln zum Anlegen eines Potentials an die hohlen Kathoden zur Bildung der reaktiven Spezien aus der genannten Quelle, und einer Reaktionskammer (110) zur Aufnahme des Gasstroms und der reaktiven Spezien.

7. Einrichtung nach Anspruch 6, wobei jede hohle Kathode ein hohles zylindrisches Rohr umfasst, wobei die zylindrischen Rohre im wesentlichen parallel zu dem Gaskanal angeordnet sind, und die zylindrischen Rohre eine Mehrzahl von Bohrungen (92, 94) aufweisen, die in einem elektrisch leitenden Körper gebildet sind, die mindestens teilweise den Gaskanal beherbergen.

8. Einrichtung nach Anspruch 7, wobei die Zuführmittel eine Sammelkammer (84) mit einem Einlaß (74) zur Aufnahme der Quelle von reaktiven Spezien, und eine Mehrzahl von Auslässen (98) aufweist, aus welchen die Quelle reaktiver Spezien zu den hohlen Kathoden zugeführt wird.

9. Einrichtung nach Anspruch 6, mit einer Anode (100) die stromab des Gaskanals und der hohlen Kathode angeordnet ist, wobei die Anode Öffnungen (104) aufweist, die mit dem Gaskanal und den hohlen Kathoden fluchtet.

10. Einrichtung nach einem der Ansprüche 6 bis 9, mit einer Mehrzahl der genannten Gaskanäle, die so angeordnet sind, dass der Gasstrom parallel durch die Gaskanäle gelangt, wobei jeder Gaskanal von einer Mehrzahl hohler Kathoden umgeben ist.

11. Einrichtung nach einem der Ansprüche 6 bis 10, die entweder eine Heizeinrichtung (124) zum Beheizen der Reaktionskammer zur Begünstigung der Reaktion zwischen den reaktiven Spezien und der Komponente des Gasstroms aufweist, oder bei welcher die Reaktionskammer wärmeisoliert ist, um die Reaktion zwischen den reaktiven Spezien und der Komponente des Gasstroms zu begünstigen.

12. Einrichtung nach einem der Ansprüche 6 bis 11, mit einem Abscheider (114) zur Aufnahme des aus der Reaktionskammer austretenden Gasstroms und zum Abscheiden festen Materials aus dem Gasstrom.

13. Einrichtung nach Anspruch 6, wobei die Einrichtung zur Behandlung eines aus einer Prozesskammer austretenden Gasstroms ausgelegt ist, zu welcher ein erster gasförmiger Vorläufer und ein zweiter gasförmiger Vorläufer abwechselnd zugeführt werden, und wobei die Mittel zum Zuführen einer gasförmigen Quelle zu der hohlen Karthode für ein Zuführen einer gasförmigen Quelle reaktiver Spezien zum Reagieren mit einem von dem ersten und dem zweiten gasförmigen Vorläufer ausgelegt sind.

14. Einrichtung nach Anspruch 13, wobei der genannte eine von dem ersten und dem zweiten gasförmigen Vorläufer der erste gasförmige Vorläufer ist, und die Quelle reaktiver Spezien der zweite gasförmige Vorläufer ist.

15. Einrichtung nach einem der Ansprüche 13 oder 14, wobei der erste gasförmige Vorläufer ein organometallischer Vorläufer ist.

## Revendications

1. Procédé de traitement d'un courant gazeux, le procédé comprenant les étapes d'acheminement du courant gazeux à travers un passage (92) pour le gaz entouré d'une pluralité de cathodes creuses (90), d'acheminement, à travers une pluralité de cathodes creuses (90), d'une source gazeuse d'espèces réactives en vue d'une réaction avec un composant du courant gazeux évacué du passage pour le gaz, d'application d'un potentiel aux cathodes creuses pour former les espèces réactives de ladite source, et, en aval du passage pour le gaz, de mélange des espèces réactives avec le courant gazeux.

2. Procédé selon la revendication 1, comprenant de plus le passage du courant gazeux à travers une pluralité desdits passages pour le gaz, agencés de telle sorte que le courant gazeux passe dans les passages pour le gaz en parallèle, chaque passage pour le gaz étant entouré d'une pluralité de cathodes creuses.

3. Procédé selon la revendication 1 ou 2, comprenant de plus le mélange des espèces réactives avec le courant gazeux dans une chambre réactionnelle située en aval du passage pour le gaz.

4. Procédé selon la revendication 3, comprenant de plus le chauffage de la chambre réactionnelle pour favoriser la réaction entre les espèces réactives et le composant du courant gazeux.

5. Procédé selon l'une quelconque des revendications précédentes, comprenant de plus l'acheminement du courant gazeux jusqu'à un séparateur pour séparer la matière solide du courant gazeux.

6. Dispositif (70) pour le traitement d'un courant gazeux, comprenant un passage (72, 82, 92) pour du gaz, destiné à recevoir le courant gazeux, une pluralité de cathodes creuses (90) situées autour du passage pour le gaz, des moyens (84) pour alimenter les cathodes creuses avec une source gazeuse d'espèces réactives en vue d'une réaction avec un composant du courant gazeux, des moyens pour appliquer un potentiel aux cathodes creuses pour former les espèces réactives à partir de ladite source, et une chambre réactionnelle (110) destinée à recevoir le courant gazeux et les espèces réactives.

7. Dispositif selon la revendication 6, dans lequel chaque cathode creuse comprend un tube cylindrique creux, les tubes cylindriques sont sensiblement parallèles au passage pour le gaz, et les tubes cylindriques comprennent une pluralité d'alésages (92, 94) formés dans un corps électro-conducteur abritant au moins partiellement le passage pour le gaz.

8. Dispositif selon la revendication 7, dans lequel les moyens d'alimentation comprennent une chambre (84) de distribution des gaz ayant une entrée (74) destinée à recevoir la source d'espèces réactives, et une pluralité de sorties (98) depuis lesquelles la source d'espèces réactives est fournie aux cathodes creuses.

9. Dispositif selon la revendication 6, comprenant une anode (100) située en aval du passage pour le gaz et de la cathode creuse, l'anode ayant des ouvertures (104) alignées avec le passage pour le gaz et les cathodes creuses.

10. Dispositif selon l'une quelconque des revendications 6 à 9, comprenant une pluralité desdits passages pour le gaz, de telle sorte que le courant gazeux passe dans les passages pour le gaz en parallèle, chaque passage pour le gaz étant entouré par une pluralité de cathodes creuses.

11. Dispositif selon l'une quelconque des revendications 6 à 10, comprenant soit un réchauffeur (124) pour chauffer la chambre de réaction afin de favoriser la réaction entre les espèces réactives et le composant du courant gazeux, soit dans lequel la chambre réactionnelle est isolée thermiquement pour favoriser la réaction entre les espèces réactives et le composant du courant gazeux.

12. Dispositif selon l'une quelconque des revendications 6 à 11, comprenant un séparateur (114) destiné à recevoir un courant gazeux évacué de la chambre réactionnelle et séparer la matière solide de ce courant gazeux.

13. Dispositif selon la revendication 6, dans lequel ledit dispositif est prévu pour traiter un courant gazeux évacué d'une chambre de traitement à laquelle un premier précurseur gazeux et un deuxième précurseur gazeux sont fournis en alternance, et dans lequel les moyens pour alimenter la cathode creuse avec une source gazeuse sont agencés pour alimenter une source gazeuse d'espèces réactives en vue d'une réaction avec l'un d'entre le premier et le deuxième précurseurs gazeux.

14. Dispositif selon la revendication 13, dans lequel ledit l'un d'entre le premier et le deuxième précurseurs gazeux est le premier précurseur gazeux, et la source d'espèces réactives est le deuxième précurseur gazeux.

15. Dispositif selon l'une quelconque des revendications 13 ou 14, dans lequel le premier précurseur gazeux est un précurseur organométallique.
